# DEMANDE DE BREVET EUROPEEN

(11) **EP 4 637 034 A1**
(43) Date de publication de la demande: **22.10.2025**
(21) Numéro de dépôt: 25169464.2
(22) Date de dépôt: 09.04.2025
(51) Int. Cl.: H03K 17/0812

(54) **CIRCUIT DE COMMANDE D'UN TRANSISTOR**

(30) Priorité: 17.04.2024 FR 2403980
(71) Demandeur: STMicroelectronics International N.V., 1228 Plan-les-Ouates, Geneva (CH)
(72) Inventeur: BRANDELERO, Julio, 31400 TOULOUSE (FR); GAYCHET, Matthieu, 31320 CASTANET-TOLOSAN (FR); ROUCH, Mickael, 31450 MONTGISCARD (FR)
(74) Mandataire: Cabinet Beaumont

(57) **Abrégé**

La présente description concerne un circuit de commande (102) pour transistor, configuré pour être relié à un transistor (110) et pour abaisser une tension appliquée sur la grille (Vgs) du transistor (110) lorsqu'un courant (Ig) délivré à ladite grille est supérieur à un premier seuil pendant une première durée.

## Description

### Domaine technique

La présente description concerne de façon générale les circuits de commande de transistor ainsi que les procédés correspondants.

### Technique antérieure

Lorsqu'un transistor, notamment un transistor de puissance, subi un court-circuit, il peut être endommagé. Certaines normes exigent que les transistors restent viables, au moins pour une durée minimale, lorsqu'un court-circuit survient.

### Résumé de l'invention

Il existe un besoin de protéger les transistors, notamment les transistors de puissance, lors de la survenue d'un court-circuit tout en respectant certaines normes.

Un mode de réalisation pallie tout ou partie des inconvénients des circuits connus.

Un mode de réalisation prévoit un circuit de commande pour transistor, configuré pour être relié à un transistor et pour abaisser une tension appliquée sur la grille du transistor lorsqu'un courant délivré à ladite grille est supérieur à un premier seuil pendant une première durée.

Un mode de réalisation prévoit un procédé de commande d'un transistor comprenant l'abaissement d'une tension appliquée sur la grille dudit transistor par un circuit de commande dudit transistor lorsqu'un courant délivré à ladite grille est supérieur à un premier seuil pendant une première durée.

Selon un mode de réalisation, le circuit de commande est configuré pour maintenir la tension appliquée sur la grille abaissée pendant une deuxième durée.

Selon un mode de réalisation, la tension appliquée sur la grille du transistor est abaissée de sorte que le transistor change d'état de conduction.

Selon un mode de réalisation, le premier seuil est supérieur ou égal à 100µA.

Selon un mode de réalisation, le premier seuil est supérieur ou égal à 400µA.

Selon un mode de réalisation, la première durée est égale ou supérieure à 100 nanosecondes.

Selon un mode de réalisation, la deuxième durée est égale ou supérieure à 200 nanosecondes.

Selon un mode de réalisation, le circuit de commande (102) comprend :
- un premier et un deuxième nœuds d'application d'une tension de commande, le deuxième nœud d'application de tension de commande étant configuré pour être relié à la source du transistor ;
- un circuit passe-haut reliant le premier nœud d'application de tension de commande à une première borne d'un premier interrupteur dont une deuxième borne est reliée à un nœud de sortie du circuit de commande, ledit nœud de sortie étant configuré pour être relié à la grille dudit transistor ; et
- un deuxième interrupteur reliant ledit nœud de sortie au deuxième nœud d'application de tension de commande, les premiers et deuxièmes interrupteurs étant configurés pour être commandés par des signaux complémentaires.

Selon un mode de réalisation, le circuit de commande comprend une deuxième capacité reliant ledit premier nœud et le deuxième nœud d'application de tension de commande.

Selon un mode de réalisation, le circuit de commande comprend :
- un premier et un deuxième nœuds d'application d'une tension de commande, le deuxième nœud d'application de tension de commande étant configuré pour être relié à la source du transistor;
- un circuit passe-bas entre le premier nœud d'application de tension de commande et un troisième nœud relié à une première borne d'un premier interrupteur,
   une deuxième borne du premier interrupteur étant reliée à un nœud de sortie du circuit de commande configuré pour être relié à la grille dudit transistor ;
- une diode Zener reliant ledit troisième nœud au deuxième nœud d'application de tension de commande ; et
- un deuxième interrupteur reliant ledit nœud de sortie au deuxième nœud d'application de tension de commande, les premiers et deuxièmes interrupteurs étant configurés pour être dans un état de conduction opposé l'un de l'autre.

Selon un mode de réalisation, le circuit passe-bas comprend :
- une résistance reliant le premier nœud d'application de tension de commande et le troisième nœud ; et
- une capacité reliant le troisième nœud et le deuxième nœud d'application de tension de commande.

Selon un mode de réalisation, le circuit de commande comprend un circuit passe-haut reliant le troisième nœud à ladite première borne du premier interrupteur.

Selon un mode de réalisation, le circuit passe-haut est composé d'une résistance en parallèle d'une capacité.

Selon un mode de réalisation, la deuxième borne du premier interrupteur est reliée au nœud de sortie du circuit de commande par l'intermédiaire d'une résistance.

Un mode de réalisation prévoit un dispositif de commande comprenant au moins un circuit de commande tel que décrit et au moins un transistor de sorte que le circuit de commande soit relié à la grille dudit transistor.

Selon un mode de réalisation, ledit transistor est un transistor à haute mobilité électronique.

Selon un mode de réalisation, le transistor est à base d'un alliage de GaN.

Un mode de réalisation prévoit un système comprenant un moteur et au moins un dispositif tel que décrit, ledit moteur étant commandé par ledit au moins un dispositif.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente très schématiquement et sous forme de blocs un exemple de système auquel s'appliquent les modes de réalisation ;
la figure 2 représente un chronogramme de fonctionnement du système de la figure 1 ;
la figure 3 représente un mode de réalisation d'un bloc de la figure 1 ;
la figure 4 représente un mode de réalisation d'un bloc de la figure 3 ;
la figure 5 représente un mode de réalisation d'un bloc de la figure 3 ;
la figure 6 représente un mode de réalisation d'un bloc de la figure 3 ;
la figure 7 représente un chronogramme de fonctionnement du bloc de la figure 4 ;
la figure 8 représente un chronogramme de fonctionnement du bloc de la figure 5 ; et
la figure 9 représente un mode de réalisation du système de la figure 1.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % ou à 10° près, de préférence à 5 % ou à 5° près.

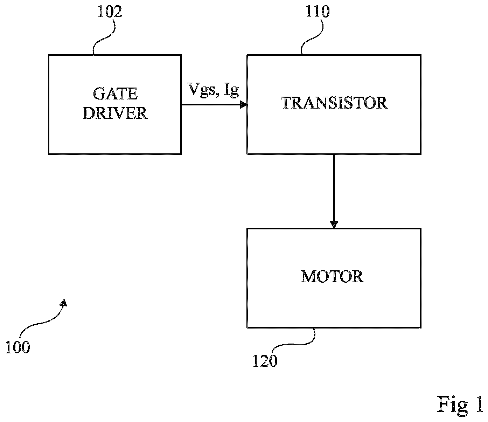

La figure 1 représente très schématiquement et sous forme de blocs un exemple de système 100 auquel s'appliquent les modes de réalisation.

Le système 100 comprend par exemple un ou plusieurs transistors 110 (TRANSISTOR) qui sont commandés par un ou plusieurs circuits de commande 102 (GATE DRIVER). Le ou les transistors 110 contrôlent par exemple l'alimentation d'un objet comme un moteur 120 (MOTOR).

Le circuit de commande contrôle l'état de conduction (passant ou ouvert) des transistors 110 en faisant varier une tension Vgs appliquée entre la grille et la source des transistors.

Les transistors 110 sont par exemple caractérisés par un courant de grille Ig qui peut traverser la grille. Autrement dit, un courant de grille est un courant délivré à la grille par le circuit de commande et qui est dû aux fuites entre la grille et la source par exemple lors de l'application de la tension Vgs.

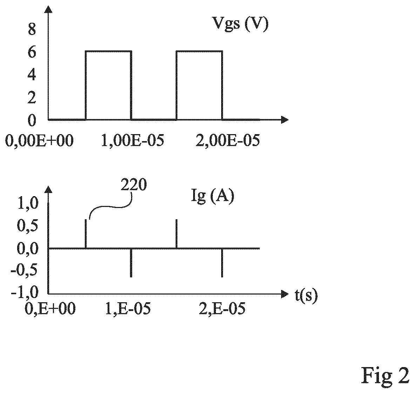

La figure 2 représente un chronogramme de fonctionnement du système de la figure 1.

Plus particulièrement, la figure 2 représente la tension Vgs appliquée à la grille du ou des transistors en fonction du temps t, indiqué en secondes, ainsi que le courant Ig, appelé courant de grille ou courant de fuite, nécessaire à charger ou décharger la tension de grille.

Dans l'exemple représenté, la tension Vgs est sous forme de créneaux et alterne par exemple toutes les 10µs entre un niveau haut qui est maintenu par exemple à 6V pendant 5µs et un niveau bas qui est maintenu par exemple à 0V (ou une tension négative) pendant 5µs. Lorsque la tension Vgs passe du niveau bas au niveau haut, un pic 220 du courant Ig se produit pendant quelques nanosecondes par exemple cinq nanosecondes à 0,6A. Il en est de même lorsque la tension Vgs passe du niveau haut au niveau bas mais avec un courant de grille de sens opposé. Ces pics de courant 220 font partie du fonctionnement du système et il peut être avantageux de les conserver.

Des normes, par exemple dans le monde de l'automobile, imposent que les transistors de commande restent viables même en subissant 10µs à au moins 60% de la tension drain source maximale admissible. Pour réaliser ce genre de test, une tension de 400V par exemple est appliquée au transistor 110 ouvert qui est monté en parallèle d'une capacité. Puis un court-circuit est créé en appliquant une tension Vgs adéquate pour fermer le transistor, par exemple 6V. La grande énergie stockée dans la capacité se vide alors très rapidement dans le transistor. Cela permet de reproduire un court-circuit se produisant par exemple dans l'objet, tel que le moteur, qui est commandé avec le transistor 110.

Différentes solutions sont envisagées pour assurer la robustesse des transistors vis-à-vis des courts-circuits se produisant en conditions réelles ou ceux engendrés pour les normes.

Une première solution est d'augmenter la résistivité à l'état passant (Ron mesurée en Ω.cm²) du transistor. Néanmoins cela grève les autres performances du circuit. Cette solution est également couteuse en termes de temps de développement et pénalise l'efficacité du transistor en période de fonctionnement normal.

Une seconde solution consiste à détecter le court-circuit puis à protéger le transistor. Il convient alors d'utiliser un capteur extrêmement rapide qui doit mesurer la tension à travers le transistor après le changement d'état de conduction du transistor ou bien de mesurer le courant principal, puis utiliser un circuit de contre-réaction pour éteindre le transistor.

La seconde solution nécessite une mesure selon une très large bande passante avec des temps de réaction très rapides pour éviter la destruction du transistor.

Pour pallier ces inconvénients, les modes de réalisation prévoient que le circuit de commande du transistor soit configuré pour abaisser la tension appliquée sur la grille Vgs dudit transistor lorsque le courant Ig, c'est-à-dire le courant de grille, délivré à ladite grille, est supérieur à un premier seuil pendant une première durée.

Les modes de réalisation utilisent avantageusement le fait que lorsque la température augmente rapidement, ce qui est le cas lors d'un court-circuit, le courant de grille Ig augmente. Dans les applications de puissance, les transistors utilisés sont par exemple des transistors à haute vitesse électronique (High Electron Mobility Transistor, HEMT, en anglais), fabriqués à base de GaN et/ou d'alliages de GaN. Pour ce type de transistors, le courant de grille peut passer d'une valeur inférieure à 600µA pour des plages de température inférieure à 150°C à des valeurs de plus de 100 mA pour des températures plus élevées atteintes lors de courts-circuits.

Déterminer que le courant délivré à la grille est supérieur à un premier seuil pendant une première durée correspond à déterminer que le courant délivré à la grille est supérieur au premier seuil de manière continue pendant la première durée. En d'autres termes, dans le but de détecter un court-circuit pour pouvoir ensuite agir sur la tension délivrée sur la grille, le courant délivré à la grille doit être supérieur au premier seuil pendant l'ensemble de la première durée.

De plus, la condition selon laquelle le courant de grille doit être supérieur au premier seuil pendant la première durée, permet de ne pas abaisser la tension appliquée à la grille lorsque les pics de courant 220 ont lieu.

Le circuit de commande peut ainsi rendre ouvert le transistor lorsque le courant de grille augmente ce qui évite que la température n'augmente encore plus lors d'un court-circuit. Le courant de court-circuit qui passe entre drain et source du transistor est ainsi arrêté ce qui évite d'endommager le transistor.

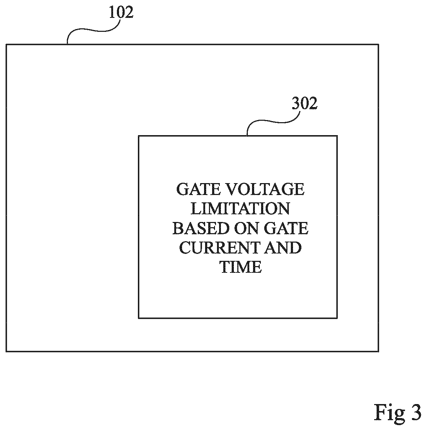

La figure 3 représente un mode de réalisation du système de la figure 1. Plus particulièrement, la figure 3 représente un exemple du circuit de commande 102.

L'exemple de circuit de commande 102 représenté s'applique par exemple pour le contrôle d'un transistor 110 dont le courant de grille évolue sensiblement (par exemple de l'ordre ou supérieur à 1µA/°C) avec la température. Dans un exemple, le circuit de commande 102 est configuré pour contrôler un ou des transistors à haute vitesse électronique et/ou à base de GaN et/ou d'alliages de GaN. Dans un exemple le ou les transistors comprennent une jonction de GaN et d'AlGaN ce qui forme un gaz d'électrons bidimensionnel. Les transistors à haute vitesse électronique sont bloqués pour des tensions grille-source inférieures à un seuil.

Dans l'exemple représenté, le circuit de commande comprend un ou des circuits 302 (GATE VOLTAGE LIMITATION BASED ON GATE CURRENT AND TIME) configurés pour abaisser la tension appliquée sur la grille Vgs du transistor lorsque le courant de grille Ig délivré à ladite grille du transistor est supérieur à un premier seuil pendant une première durée.

Dans un exemple, le premier seuil est égal ou supérieur à 100µA ou plus particulièrement égal ou supérieur à 400µA.

Dans un autre exemple, la première durée est égale ou supérieure à 100ns, plus particulièrement égale ou supérieure à 200ns.

Si un pic de courant 220 a lieu, la tension de grille n'est pas abaissée, car le pic a une durée inférieure à la première durée, ce qui permet d'assurer un fonctionnement normal du circuit hors conditions de court-circuit.

Lors d'un court-circuit, la température du transistor augmente drastiquement en quelques dizaines de nanosecondes ce qui augmente en retour le courant de grille. Si le courant de grille dépasse le premier seuil pendant toute la première durée alors la tension de grille est abaissée par exemple jusqu'à la valeur de saturation de la tension de grille. Le transistor change alors par exemple d'état de conduction ce qui le protège lors du passage d'un état fermé à un état ouvert.

Dans un exemple, le circuit de commande 102 est configuré pour maintenir la tension de grille abaissée à un niveau bas, par exemple à un niveau où l'état de conduction du transistor est non-passant, et ce pendant une deuxième durée. Cela permet par exemple que la situation ayant abouti au court-circuit puisse disparaître avant que le transistor ne reprenne un fonctionnement standard.

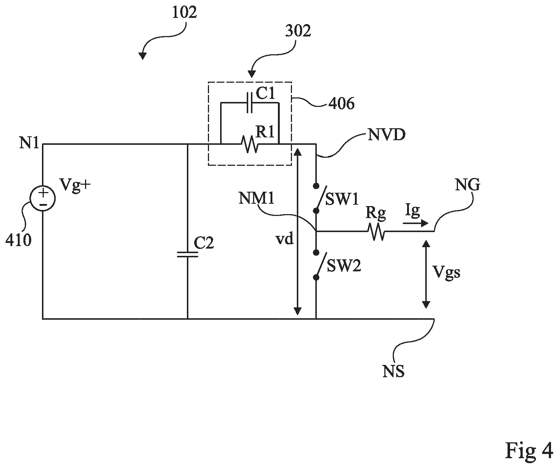

La figure 4 représente un mode de réalisation d'un bloc de la figure 3. Plus particulièrement, la figure 4 représente un exemple du circuit de commande 102.

Dans l'exemple représenté, le circuit de commande 102 comprend une source d'alimentation électrique 410 appliquant une tension de commande Vg+ entre un nœud N1 et un nœud NS. Le nœud NS est configuré pour être relié, préférablement connecté, à la source du transistor 110 à commander.

Dans l'exemple représenté, le circuit de commande 102 comprend en outre un circuit passe-haut 406, autrement dit un filtre passe-haut, reliant le nœud N1 à une première borne NVD d'un premier interrupteur (ou commutateur) SW1. Une deuxième borne NM1 du premier interrupteur SW1 est reliée à un nœud de sortie NG du circuit de commande 102 par l'intermédiaire d'une résistance Rg. Le nœud de sortie NG est configuré pour être relié à la grille du transistor 110 à commander.

Dans l'exemple représenté, le circuit de commande 102 comprend un deuxième interrupteur (ou commutateur) SW2 reliant le nœud NG au nœud NS. Dans un exemple les premiers et deuxièmes interrupteurs sont configurés pour être dans un état de conduction opposé l'un de l'autre. Dans un autre exemple, l'interrupteur SW1 est un transistor NMOS et le transistor SW2 est un transistor PMOS. Dans un exemple, l'interrupteur SW1 est un transistor PMOS et le transistor SW2 est un transistor NMOS. Les signaux de commande de ces deux interrupteurs sont par exemple opposés en utilisant par exemple un circuit inverseur sur l'un des signaux de commande IN des interrupteurs. Le circuit formé par les deux interrupteurs est un circuit de type « push-pull » qui permet d'amplifier par exemple et de créer un signal carré ou créneau entre les nœuds NG et NS.

Dans l'exemple représenté, le circuit de commande 102 comprend en outre une deuxième capacité C2, facultative, reliant le nœud N1 et le nœud NS. Dans cet exemple, le rôle de la capacité C2 est de fournir les pics de courant 220.

Dans un exemple, le circuit passe-haut 406 est formé par une capacité C1 en parallèle d'une résistance R1 entre les nœuds NVD et N1.

Dans un exemple, la résistance R1 a par exemple une valeur de l'ordre de la dizaine d'Ohms, C2 est de l'ordre du µF et C1 de l'ordre de la dizaine de nF.

En fonctionnement, les pics de courant 220 sont de l'ordre de quelques nanosecondes ce qui correspond à des fréquences supérieures ou égales à 10 MHz par exemple. Ces pics de courant vont circuler dans le circuit passe-haut 406 à partir de la capacité C1, et facultativement aussi de la capacité C2, et pas ou peu à travers R1, ce qui va créer un chemin de basse impédance. Le courant de grille dû au court-circuit, et délivré à la grille à partir de la source d'alimentation électrique 410, n'est pas sous forme de pics et correspond donc à des fréquences plus basses de l'ordre de quelques centaines de kHz. Ce courant de grille va circuler à travers C1 et en plus R1 ce qui forme un chemin de plus haute impédance qui atténue la tension Vg+ délivrée par la source d'alimentation électrique 410. La tension Vgs délivrée à la grille s'en retrouve donc atténuée automatiquement jusqu'à par exemple passer sous le seuil de conduction du transistor.

Dans l'exemple représenté, les valeurs de C1, et éventuellement C2, et R1 seront choisies pour ne pas atténuer les fréquences supérieures à 10 MHz et atténuer les fréquences de l'ordre de quelques centaines de kHz. Plus la valeur de R1 est élevée, plus la chute de tension appliquée à la grille du transistor lors d'un court-circuit sera élevée.

L'exemple de la figure 4 permet que la tension de grille soit abaissée automatiquement lorsque le courant de grille dépasse le premier seuil pendant la première durée sans nécessité de mesure ou de boucle de contre-réaction. Cela augmente la vitesse permettant de protéger le transistor et diminue le coût de mise en oeuvre tout en limitant l'impact sur les performances.

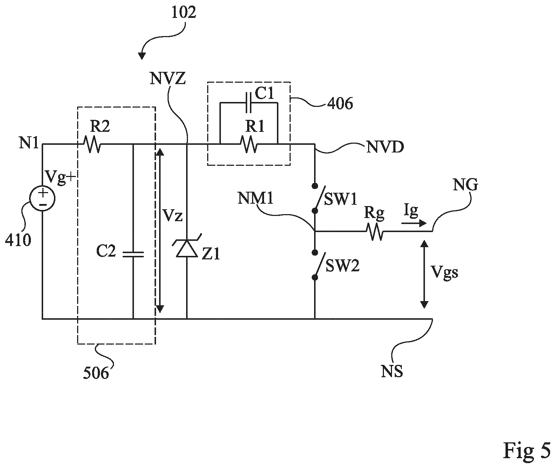

La figure 5 représente un mode de réalisation d'un bloc de la figure 3. Plus particulièrement, la figure 5 représente un exemple du circuit de commande 102.

Dans l'exemple représenté, le circuit de commande 102 comprend la source d'alimentation 410 ainsi que les nœuds N1, NS qui sont similaires à ceux de la figure 4. Les deux interrupteurs SW1 et SW2 ainsi que la résistance Rg sont également similaires à ceux de la figure 4. Le circuit de commande 102 comprend en outre un circuit passe-bas 506, autrement dit un filtre passe-bas, entre le nœud N1 et un nœud NVZ relié à la première borne du premier interrupteur SW1. Le circuit de commande 102 comprend également une diode Zener Z1 reliant le nœud NVZ au nœud NS avec la cathode de la diode Z1 orientée vers le nœud NVZ. Dans l'exemple représenté, le filtre passe-bas 506 est implémenté avec une résistance R2 qui relie le nœud N1 et le nœud NVZ ; et avec la capacité C2 qui relie cette fois le nœud NVZ et le nœud NS.

Dans l'exemple de la figure 5, le filtre passe-haut 406 est facultatif et il peut être implémenté, dans un exemple, entre le nœud NVZ et le nœud NVD.

Dans un exemple de la figure 5, la capacité C2 est de l'ordre de 100nF, la capacité C1 est d'environ 10nF, la résistance R1 d'environ 10 Ohms et R2 d'environ 500 Ohms.

En fonctionnement, le filtre passe-bas charge lentement la capacité C2 à travers la résistance R2. Comme la diode Zener Z1 est présente en antiparallèle avec la capacité C2, la résistance R2 peut être choisie comme assez grande, de l'ordre de plusieurs centaines d'Ohms, pour assurer un régime opérationnel normal. Lors d'un court-circuit, le fonctionnement est similaire à celui de la figure 4 sauf que la tension Vgs est maintenue en dessous d'un niveau bas, par exemple en dessous du seuil de conduction du transistor, pendant une durée supérieure à 10µs par exemple, ce qui permet de ne pas réarmer le court-circuit trop rapidement. Cela permet également de laisser du temps pour avertir une unité de contrôle d'un moteur par exemple relié, préférablement connecté, au transistor.

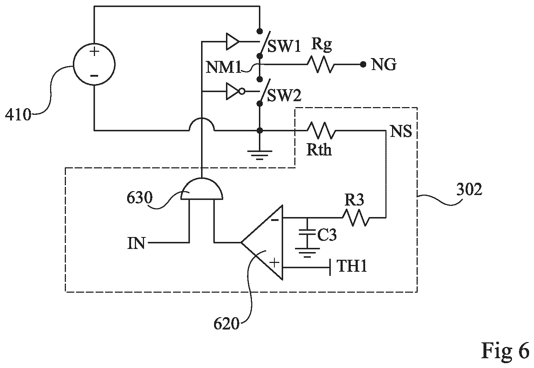

La Figure 6 représente un mode de réalisation d'un bloc de la figure 3. Plus particulièrement, la figure 6 représente un exemple du circuit de commande 102.

Dans l'exemple représenté, le circuit de commande 102 comprend la source d'alimentation 410 qui est similaire à celle de la figure 4. La source d'alimentation est référencée à la masse locale. Le nœud NS est, dans cet exemple, relié à la masse locale par l'intermédiaire d'une résistance de mesure Rth. Les deux interrupteurs SW1 et SW2 ainsi que la résistance Rg sont également similaires à ceux de la figure 4. Dans l'exemple représenté, l'interrupteur SW1 est connecté directement à la source d'alimentation.

Dans l'exemple représenté, le circuit de limitation de tension 302 comprend en outre la résistance de mesure Rth, et un circuit passe-bas référencé à la masse, autrement dit un filtre passe-bas, entre le nœud NS et une entrée négative, notée « - » d'un comparateur 620. Le circuit passe-bas est, dans l'exemple représenté, composé d'une résistance R3 reliant le nœud NS à l'entrée « - » du comparateur 620, et d'une capacité C3 reliant l'entrée « - » du comparateur 620 à la masse. Une entrée positive du comparateur 620, notée « + », est reliée à un rail de tension configuré pour recevoir une tension de seuil TH1. La sortie du comparateur est reliée à une entrée d'une porte logique 630 de type « ET ». Une autre entrée de la porte logique 630 est configurée pour recevoir un signal de contrôle IN du circuit de contrôle 102. Les signaux de contrôle des interrupteurs SW1 et SW2 sont inversés l'un par rapport à l'autre et sont issus du signal présent à la sortie de la porte logique 630.

En fonctionnement, la résistance de mesure Rth transforme le courant de grille Ig en une tension proportionnelle à la valeur de la résistance Rth. Le filtre passe-bas, composé de R3 et C3, charge lentement la capacité C3 à travers la résistance R3. En cas de pics de courants 220, la tension négative du comparateur n'atteint pas le niveau de la tension de seuil TH1 imposée et le comparateur 620 impose le niveau logique 1 à la porte logique « ET » 630. En cas de court-circuit et d'une augmentation du courant de grille, la tension négative du comparateur atteint la tension du seuil TH1 et le comparateur 620 impose le niveau logique 0 à la porte logique « ET » 630 qui amorce l'interrupteur SW2 et imposera une tension Vgs nulle ce qui arrête le courant de court-circuit.

Dans un exemple, la valeur de Rth est d'environ 2Ω, R3 est d'environ 50 Ω, C1 d'environ 1nF, et la tension de seuil TH1 d'environ 0,1V.

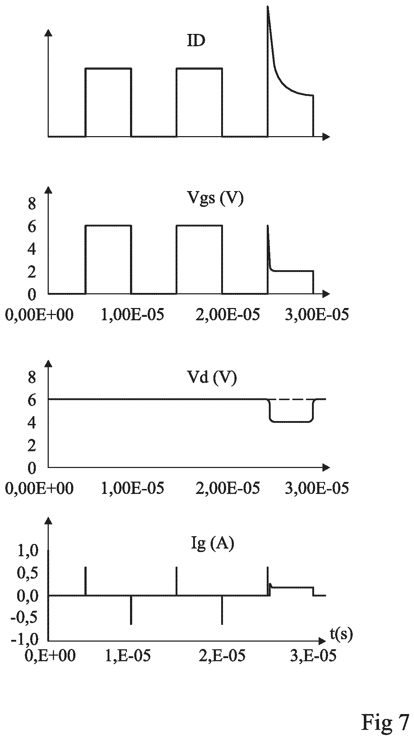

La figure 7 représente un chronogramme de fonctionnement du bloc de la figure 4. Plus particulièrement, la figure 7 représente la tension Vgs, une tension Vd entre le nœud NVD et le nœud NS, le courant de grille Ig, et le courant de drain ID qui parcourt le drain du transistor, en fonction du temps t exprimé en secondes.

Le début de l'exemple de la figure 7 est similaire au fonctionnement de la figure 2. La tension Vgs suit des créneaux entre environ 6V et un niveau bas à 0V ou négatif par exemple. A chaque passage d'un niveau à un autre se produit un pic de courant 220.

Au début du troisième créneau, à environ 25µs, un court-circuit intervient, par exemple à cause d'un courant trop élevé demandé par un moteur relié, préférablement connecté au transistor. Le courant de drain ID du transistor augmente, lors du court-circuit, hors de la plage de fonctionnement normal du transistor. La température augmente ainsi au sein du transistor, ce qui augmente le courant de grille qui passe d'un niveau proche de zéro à environ 200mA. En réaction, le circuit de commande 102 abaisse la tension Vgs de 6V à 2V en quelques centaines de nanosecondes, par exemple 300ns. La tension Vd est également abaissée rapidement de 6 à 4V ce qui diffère par exemple du comportement habituel des circuits de commande qui est représenté par le trait en pointillé et qui maintiennent la tension Vd quel que soit la valeur du courant de grille Ig.

A la fin du troisième créneau, vers 30 µs, le niveau de Vgs est ramené au niveau bas par le circuit push-pull et donc le transistor devient non passant, le courant de grille revient à un niveau bas et la tension Vd revient à 6V.

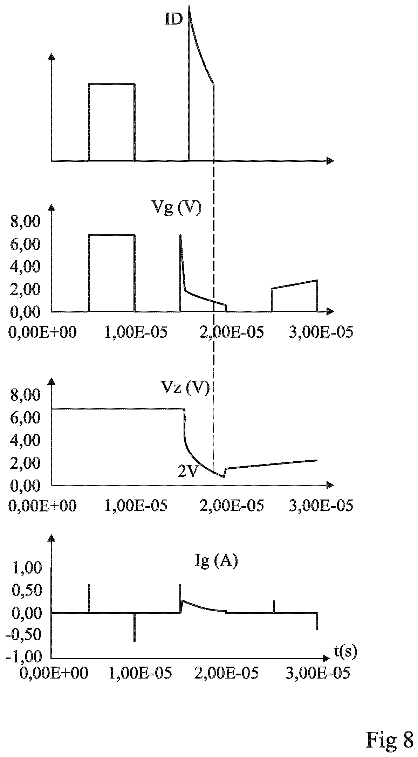

La figure 8 représente un chronogramme de fonctionnement du bloc de la figure 5.

Plus particulièrement, la figure 8 représente la tension Vgs, une tension Vz entre le nœud NVZ et le nœud NS, le courant de grille Ig, et le courant de drain ID qui parcourt le drain du transistor, en fonction du temps t exprimé en secondes.

Entre 0 et 15µs, l'exemple de la figure 8 est similaire à celui de la figure 2 ou 7. Lorsque le deuxième créneau de Vgs passe de 0 à 6V, à 15µs, un court-circuit survient (symbolisé par une flèche). Le courant de drain ID augmente hors de la plage de fonctionnement normal du transistor. Le courant de grille augmente alors très rapidement. En retour, la tension Vz baisse en moins d'une centaine de nanosecondes de 6V à 4V environ puis baisse un peu moins rapidement jusqu'à 2V vers la fin du deuxième créneau vers 20µs. La tension Vgs suit un même comportement mais elle baisse rapidement de 6 à 2V puis plus lentement jusqu'à 0,5V environ jusqu'à la fin du deuxième créneau. Le courant de drain ID est complètement bloqué lorsque la tension Vgs est inférieure au seuil de mise à conduction du transistor. Le courant de grille baisse également en conséquence.

A partir de la fin du deuxième créneau à 20µs, la tension Vz remonte lentement, par exemple linéairement.

Contrairement à l'exemple de la figure 7, dans l'exemple de la figure 8, la tension Vgs met ainsi plus de temps, par exemple 30µs, avant de repasser au-dessus du niveau rendant le transistor passant, ce qui crée un temps de masquage qui peut durer le temps d'un ou plusieurs autres créneaux.

L'exemple de la figure 8 permet d'arrêter rapidement le court-circuit et permet la transmission de l'information de la présence d'un court-circuit avant de permettre au transistor d'être passant de nouveau.

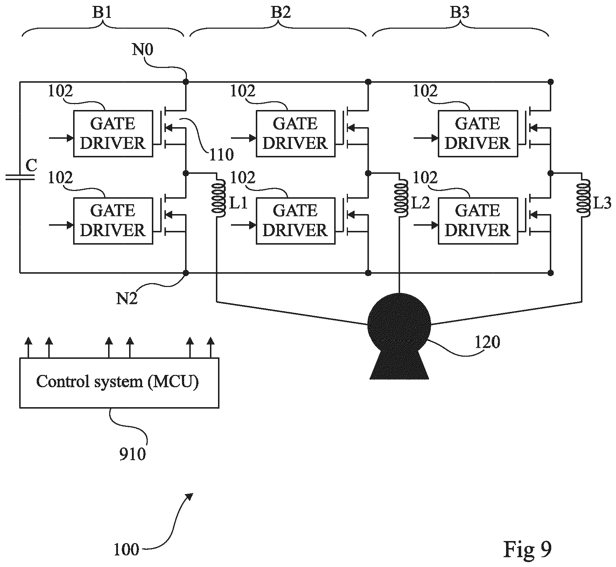

La figure 9 représente un mode de réalisation du système de la figure 1.

Dans l'exemple représenté, le système 100 comprend un circuit de commande moteur pour contrôler le moteur 120. Le circuit de commande moteur comprend par exemple plusieurs branches B1, B2, B3 reliées en parallèle entre un nœud N0 et un nœud N2. Dans cet exemple, une capacité C relie également les nœuds N0 et N2.

Dans chaque branche, un premier transistor a son drain relié, préférablement connecté, au nœud N0 et sa source reliée, préférablement connectée, à un nœud NM2, et un deuxième transistor a son drain relié, préférablement connecté, au nœud NM2 et sa source reliée, préférablement connectée, au nœud N2.

Chacun des transistors de chaque branche est commandé par un circuit de commande 102 tel que celui des figures 4 ou 5. Chaque circuit de commande d'une branche a son nœud NG relié, préférablement connecté, à la grille d'un transistor et son nœud NS relié, préférablement connecté, à la source du transistor respectif.

Dans l'exemple représenté, le nœud NM2 de chaque branche B1, B2 ou B3 est relié, préférablement connecté, à une phase d'alimentation du moteur 120 par l'intermédiaire d'une inductance de lissage L1, L2, L3 respectivement.

Dans l'exemple de la figure 9, le système 100 comprend également une unité de commande 910 (Control system (MCU)) configurée par exemple pour générer le signal de commande des interrupteurs SW1 et SW2 de chaque circuit de commande 102.

Le système 100 de la figure 9 permet d'obtenir des transistors de commande de moteur qui sont protégés plus efficacement contre les courts-circuits et qui permettent de répondre aux normes.

Les exemples de circuits de commande présentés peuvent être appliqués par exemple dans l'industrie automobile, dans des application radio fréquence, les systèmes radars ou les amplificateurs microondes, dans les amplificateurs audio ou les transmetteurs radiofréquence, ainsi que pour l'électrification des véhicules en particulier les véhicules électriques et hybrides, ou bien dans les systèmes d'éclairage à diodes électroluminescentes pour la gestion des courants et des tensions ainsi que pour l'amélioration de l'efficacité et des performances.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les valeurs des résistances R1, R2, des capacités C1 ou C2 pourront être modifiées par la personne de l'art pour permettre un abaissement plus ou moins rapide de la tension Vgs après détection d'une augmentation du courant de grille au-delà d'un seuil pour une durée donnée ainsi que de modifier la période de masquage.

Enfin, la mise en oeuvre pratique des modes de réalisation et variantes décrits est à la portée de la personne du métier à partir des indications fonctionnelles données ci-dessus. En particulier, les circuits de commande décrits peuvent servir à commander différents types de transistors autres que des transistors HEMT et/ou à base d'alliages de GaN, et notamment des transistors dont le courant de grille au niveau de la grille varie sensiblement avec la température. Additionnellement, pour ce qui est des filtres passe-haut et passe bas, la personne du métier pourra mettre en oeuvre d'autres implémentations de ces filtres que celles présentées avec les résistances R1 et C1 ou R2 et C2. De plus, même si les exemples donnés dans les figures s'appliquent par exemple au cas d'une commande moteur, le circuit de commande décrit pourra être appliqué à d'autres applications.

## Revendications

1. Circuit de commande (102) pour transistor, configuré pour être relié à un transistor (110) et pour abaisser une tension appliquée sur la grille (Vgs) du transistor (110) lorsqu'un courant (Ig) délivré à ladite grille est supérieur à un premier seuil pendant une première durée.

2. Procédé de commande d'un transistor comprenant l'abaissement d'une tension appliquée sur la grille (Vgs) dudit transistor par un circuit de commande dudit transistor lorsqu'un courant (Ig) délivré à ladite grille est supérieur à un premier seuil pendant une première durée.

3. Circuit selon la revendication 1 ou procédé selon la revendication 2, dans lequel le circuit de commande (102) est configuré pour maintenir la tension appliquée sur la grille (Vgs) abaissée pendant une deuxième durée.

4. Circuit selon l'une quelconque des revendications 1 ou 3, ou procédé selon l'une quelconque des revendications 2 ou 3, dans lequel la tension appliquée sur la grille du transistor est abaissée de sorte que le transistor change d'état de conduction.

5. Circuit selon l'une quelconque des revendications 1 ou 3 ou 4, ou procédé selon l'une quelconque des revendications 2 à 4, dans lequel le premier seuil est supérieur ou égal à 100µA.

6. Circuit ou procédé selon la revendication 5, dans lequel le premier seuil est supérieur ou égal à 400µA.

7. Circuit selon l'une quelconque des revendications 1 ou 3 à 6, ou procédé selon l'une quelconque des revendications 2 à 6, dans lequel la première durée est égale ou supérieure à 100 nanosecondes.

8. Circuit ou procédé selon la revendication 4 à 7 dans leur dépendance à la revendication 4, dans lequel la deuxième durée est égale ou supérieure à 200 nanosecondes.

9. Circuit selon l'une quelconque des revendications 1 ou 3 à 8, ou procédé selon l'une quelconque des revendications 2 à 8, dans lequel le circuit de commande (102) comprend :
- un premier et un deuxième nœuds (N1,NS) d'application d'une tension de commande (Vg+), le deuxième nœud (NS) d'application de tension de commande étant configuré pour être relié à la source du transistor ;
- un circuit passe-haut (406) reliant le premier nœud (N1) d'application de tension de commande à une première borne (NVD) d'un premier interrupteur (SW1) dont une deuxième borne (NM1) est reliée à un nœud de sortie (NG) du circuit de commande (102), ledit nœud de sortie (NG) étant configuré pour être relié à la grille dudit transistor ; et
- un deuxième interrupteur (SW2) reliant ledit nœud de sortie (NG) au deuxième nœud d'application de tension de commande (NS), les premiers et deuxièmes interrupteurs étant configurés pour être commandés par des signaux complémentaires.

10. Circuit ou procédé selon la revendication 9, dans lequel le circuit de commande comprend une deuxième capacité (C2) reliant ledit premier nœud (N1) et le deuxième nœud (NS) d'application de tension de commande.

11. Circuit selon l'une quelconque des revendications 1 ou 3 à 8, ou procédé selon l'une quelconque des revendications 2 à 8, dans lequel le circuit de commande (102) comprend :
- un premier et un deuxième nœuds (N1,NS) d'application d'une tension de commande (Vg+), le deuxième nœud (NS) d'application de tension de commande étant configuré pour être relié à la source du transistor;
- un circuit passe-bas (506) entre le premier nœud (N1) d'application de tension de commande et un troisième nœud (NVZ) relié à une première borne (NVD) d'un premier interrupteur (SW1),
une deuxième borne (NM1) du premier interrupteur (SW1) étant reliée à un nœud de sortie (NG) du circuit de commande configuré pour être relié à la grille dudit transistor ;
- une diode Zener (Z1) reliant ledit troisième nœud (NVZ) au deuxième nœud (NS) d'application de tension de commande ; et
- un deuxième interrupteur (SW2) reliant ledit nœud de sortie (NG) au deuxième nœud (NS) d'application de tension de commande, les premiers et deuxièmes interrupteurs étant configurés pour être dans un état de conduction opposé l'un de l'autre.

12. Circuit ou procédé selon la revendication 11, dans lequel le circuit passe-bas (506) comprend :
- une résistance (R2) reliant le premier nœud (N1) d'application de tension de commande et le troisième nœud (NVZ) ; et
- une capacité (C2) reliant le troisième nœud (NVZ) et le deuxième nœud (NS) d'application de tension de commande.

13. Circuit ou procédé selon la revendication 11 ou 12, dans lequel le circuit de commande comprend un circuit passe-haut (406) reliant le troisième nœud (NVZ) à ladite première borne (NVD) du premier interrupteur (SW1).

14. Circuit ou procédé selon l'une quelconque des revendications 9, 10 ou 13, dans lequel le circuit passe-haut est composé d'une résistance (R1) en parallèle d'une capacité (C1).

15. Circuit ou procédé selon l'une quelconque des revendications 8 à 14, dans lequel la deuxième borne (NM1) du premier interrupteur (SW1) est reliée au nœud de sortie (NG) du circuit de commande par l'intermédiaire d'une résistance (Rg).

16. Circuit selon l'une quelconque des revendications 1 ou 3 à 15, ou procédé selon l'une quelconque des revendications 2 à 15, dans lequel la tension appliquée sur la grille (Vgs) du transistor (110) est abaissée lorsque le courant (Ig) délivré à ladite grille est supérieur au premier seuil de manière continue pendant toute la première durée.

17. Dispositif de commande comprenant au moins un circuit de commande (102) selon l'une quelconque des revendications 1 ou 3 à 16, et au moins un transistor (110) de sorte que le circuit de commande (102) soit relié à la grille dudit transistor (110).

18. Dispositif selon la revendication 17, dans lequel ledit transistor (110) est un transistor à haute mobilité électronique.

19. Dispositif selon la revendication 17 ou 18, dans lequel le transistor (110) est à base d'un alliage de GaN.

20. Système comprenant un moteur (120) et au moins un dispositif selon l'une quelconque des revendications 17 à 19, dans lequel ledit moteur est commandé par ledit au moins un dispositif.
